# EUROPEAN PATENT SPECIFICATION

(11) **EP 2 772 728 B1**
(45) Date of publication and mention of the grant of the patent: **09.08.2017**
(21) Application number: 12843767.0
(22) Date of filing: 03.09.2012
(51) Int. Cl.: G01D 11/24, F16H 59/70, G01B 7/30, G01M 17/007, G01D 5/14

(54) **DETECTING SENSOR MANUFACTURING METHOD**
HERSTELLUNGSVERFAHREN FÜR EINEN DETEKTIONSSENSOR
PROCÉDÉ DE FABRICATION DE CAPTEUR DE DÉTECTION

(30) Priority: 27.10.2011 JP 2011235986
(43) Date of publication of application: 03.09.2014
(60) Divisional application: 16162339.2
(73) Proprietor: Tyco Electronics Japan G.K., Kawasaki-shi, Kanagawa 213-8535 (JP); Honda Motor Co., Ltd., Tokyo 107-8556 (JP)
(72) Inventor: MINEMATSU, Takayuki, Kawasaki-shi, Kanagawa 213-8535 (JP); NAKAI, Takanori, Kawasaki-shi, Kanagawa 213-8535 (JP); FUKAMIZU, Nobutaka, Wako-shi, Saitama 351-0113 (JP); KITAJIMA, Kyoji, Minato-ku, Tokyo 107-8556 (JP)
(74) Representative: Johnstone, Douglas Ian
(86) International application number: PCT/JP2012/005561
(87) International publication number: WO 2013/061503

(56) References cited:
- WO-A2-2009/015990
- DE-A1-102006 008 478
- JP-A- 2001 116 815
- JP-A- 2002 181 909
- JP-A- 2009 271 000
- JP-A- 2011 086 479
- US-A1- 2007 075 705
- US-A1- 2008 012 555
- US-A1- 2008 106 873
- US-A1- 2008 237 818

## Description

### Technical Field

The present invention relates to a method for manufacturing a detecting sensor using magnetism.

### Background Art

In automobiles or the like, it is well known that electronic control is more and more employed, and detecting sensors for detecting the operation of various parts or the like for control are quite often used. In such the detecting sensors, it is detected whether or not the parts are at predetermined positions by using magnetism or the like.

Among these detecting sensors, a detecting sensor that detects the operation of an important part such as a part involved in running control itself of automobiles is multiplexed (see Patents JP8-49575A and JP 3491587B). That is, a plurality of, e.g., two, sensor elements are provided, and even when a malfunction occurs in one of the sensor elements or the like, detection is performed by using the other sensor element, or detection results of one and the other of the sensor elements are compared to perform failure diagnosis of the sensor elements.

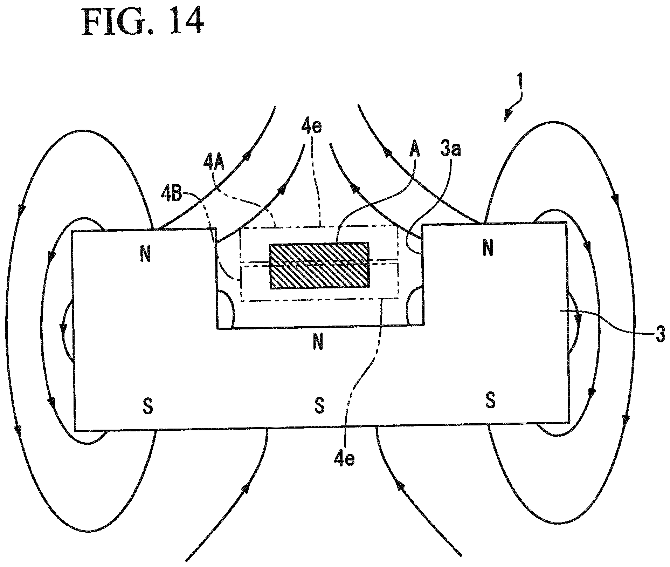

FIG. 14 shows the configuration of an existing detecting sensor manufactured by the present applicants. As shown in FIG. 14, a detecting sensor 1 has a configuration in which a magnet 3 having, for example, a substantially U shape in section and two sensor elements 4A and 4B are held in an unillustrated housing. A recess 3a that opens on one side thereof is provided in the magnet 3. In the magnet 3, a region A with no magnetic flux exists inside the recess 3a. The two sensor elements 4A and 4B are arranged in the region A with no magnetic flux.

Patent WO 2009/015990 discloses a method of injection molding a motion sensor including a permanent magnet and an integrated circuit. The method involves the use of a mold with upper and lower mold parts between which a permanent magnet and an adjacent integrated circuit are positioned. A so-called fixing insert or first core extends into the mold and performs a support function for parts in the mold during a first injection molding step. The fixing insert is then withdrawn and replaced by a so-called second core, following which a second injection molding or encapsulation step takes place. Conductor terminals from the integrated circuit are connected by crimp connections to connection wires of a connection cable which extends along a parting plane between the mold parts to an exterior of the mold.

### Summary of Invention

### Technical Problem

When the detecting sensor 1 as described above is mass-produced, it is important to maintain high location accuracy for the magnet 3 and the sensor elements 4A and 4B. This is because there occurs a variation in detection results of a plurality of detecting sensors 1, which directly affects product accuracy if there is a variation in the positions of the sensor elements 4A and 4B with respect to the magnet 3.

To solve the problem, the magnet 3 and the sensor elements 4A and 4B may be fixed to the housing (not shown) of the detecting sensor 1 with high accuracy. However, the sensor elements 4A and 4B including hall elements are positioned in the housing (not shown) through body sections 4e in each of which an element body and one end of a terminal are embedded. Here, the body sections 4e are molded bodies made of insulating resin, and thus do not have high molding accuracy in most cases. Therefore, there is a limit to improve the location accuracy of the magnet 3 and the sensor elements 4A and 4B by fixing the sensor elements 4A and 4B to the housing through the body sections 4e.

Thus, the molding accuracy of the body sections 4e of the sensor elements 4A and 4B may be improved; however, it costs a lot and is thus not realistic to do so.

The present invention has been accomplished in view of the technical problems as described above, and an object thereof is to provide a method for manufacturing a detecting sensor which can stably provide high detection accuracy at low cost.

### Solution to Problem

A method for manufacturing a detecting sensor according to the present invention that has been accomplished to achieve the above object including: a magnet that generates a magnetic field; a plurality of sensor elements that detect a change in the magnetic field generated by the magnet; and a housing that holds the magnet and the sensor elements, the method comprising the steps of: fixing the magnet and the sensor elements to a mold; molding the housing by injecting molten resin into the mold and curing the molten resin; and removing the detecting sensor in which the magnet and the sensor elements are integrated with the housing from the mold, wherein in the step of fixing the magnet and the sensor elements to the mold, the sensor elements are fixed to the mold by inserting terminals projecting from bodies of the sensor elements into terminal insertion holes formed in the mold. Since each of the sensor elements is fixed to the mold by inserting the terminals of the sensor element into the terminal insertion holes in the mold as described above, the sensor elements can be positioned with respect to the mold with high accuracy. By injecting the molten resin into the mold in this state to form the housing, the detecting sensor is formed while the sensor elements are positioned with respect to the magnet with high accuracy.

Also, the housing preferably includes a positioning holding section that positions each of the sensor elements by abutting against only a portion of a surface of the body of the sensor element. Since the holding section contacts only a portion of the body of the sensor element, heat dissipation properties of the sensor element can be improved. Also, the holding section may be configured to hold each of the sensor elements by extending in a direction perpendicular to the surface of the body of the sensor element and causing a distal end portion thereof to abut against the body. In this case, in the step of molding the housing, the molten resin is caused to flow from a proximal end portion to the distal end portion of the holding section to press the body of the sensor element by the molten resin and form the holding section. Accordingly, the sensor element can be reliably positioned.

By the way, in recent automobiles, the degree of layout freedom of parts is reduced along with an increase in the number of parts. In such circumstances, when two sensor elements are provided, the detecting sensor, of course, has a larger size, and it may become difficult to arrange the detecting sensor at an appropriate position with respect to an object to be detected. Also, there is a problem that modification is required on the side of the object to be detected so as to arrange the detecting sensor, which increases costs. Thus, here, although the plurality of sensor elements may be arranged in any manner, the plurality of sensor elements are preferably arranged with surfaces of the bodies abutting against each other. By causing the surfaces of the bodies of the sensor elements to abut against each other as described above, the detecting sensor can be reduced in size, easily arranged, and mounted at low cost without particularly making modification on the object to be detected. Also, in a case in which the object to be detected is a rotating body and the detecting sensor detects a rotating operation of the object to be detected, the magnetic field generated by the magnet is easily strained by the influence of rotation of the object to be detected, and detection accuracy is easily affected. On the other hand, by arranging detecting element bodies of the plurality of sensor elements adjacent to each other, the influence of the magnetic (magnetic field) strain can be minimized, and the detection accuracy can be improved. Also, by decreasing a gap between the sensor elements, the detecting sensor can be reduced in size, arranged with a higher degree of freedom, and easily mounted.

Also described below is a detecting sensor including: a magnet that generates a magnetic field; a plurality of sensor elements that detect a change in the magnetic field generated by the magnet; and a housing that holds the magnet and the sensor elements, wherein each of the plurality of sensor elements includes a body and a terminal projecting from the body, and the plurality of sensor elements are held in the housing with the bodies overlapped with each other in a state in which the terminals project in a same direction from the bodies. The housing is held so as to be sandwiched between a first holding section that abuts against a portion of a surface of the body of the sensor element on one side of the plurality of sensor elements whose bodies are overlapped with each other, and a second holding section that is provided so as to cross a portion of a surface of the body of the sensor element on another side of the plurality of sensor elements. The detecting sensor as described above is preferably manufactured by a method for manufacturing a detecting sensor according to any one of claims 1 to 5 as described above.

Also described below is a transmission including: a shift select shaft that moves in an axial direction to perform one of a select operation and a shift operation, and rotates about an axis line to perform another of the select operation and the shift operation; a detection projection that is provided on an outer peripheral portion of the shift select shaft; and a detecting sensor according to claim 6 or 7 as described above that detects whether or not the detection projection is at a prescribed position determined in advance.

### Advantageous Effects of Invention

In accordance with the present invention, each of the sensor elements is fixed to the mold by inserting the terminals of the sensor elements into the terminal insertion holes in the mold, so that the sensor elements can be positioned with respect to the mold with high accuracy. By injecting the molten resin into the mold in this state to form the housing, the detecting sensor can be formed while the sensor elements are positioned with respect to the magnet with high accuracy. This is achieved only by forming the terminal insertion holes in the mold, so that the above effects can be obtained at low cost.

Consequently, the detecting sensor capable of stably exhibiting high detection accuracy at low cost can be provided.

### Brief Description of Drawings

FIG. 1 is an elevation view illustrating the configuration of a transmission of an automobile.
FIG. 2 is a plan view illustrating a main portion in FIG. 1.
FIG. 3 is a view illustrating an installment state of a detecting sensor with respect to the transmission.
FIG. 4 is a perspective view illustrating the entire configuration of the detecting sensor.
FIG. 5 is a sectional view of the detecting sensor in a direction along an axis line.
FIG. 6A is a plan view and FIG. 6B is a front view of a distal end portion of the detecting sensor.
FIG. 7A is a sectional view along A-A in FIG. 6, and FIG. 7B is a sectional view along B-B in FIG. 7A.
FIG. 8A is an enlarged perspective view and FIG. 8B is an enlarged sectional view of the distal end portion of the detecting sensor.
FIG. 9 is a view illustrating a side where holding holes for holding terminals of sensor elements are formed in a mold for forming a housing of the detecting sensor.
FIG. 10 is a view illustrating a state in which a magnet is set in the mold shown in FIG. 9.
FIG. 11 is a view illustrating a state in which the magnet and the sensor elements are set in the mold shown in FIG. 9.
FIG. 12 is a view illustrating the configuration of a parking lock device in a parking released state in the present embodiment.
FIG. 13 is a view illustrating the parking lock device in FIG. 12 in a parking active state.
FIG. 14 is a view illustrating the positions of sensor elements in a magnetic field generated by a magnet in a conventional detecting sensor.

### Description of Embodiments

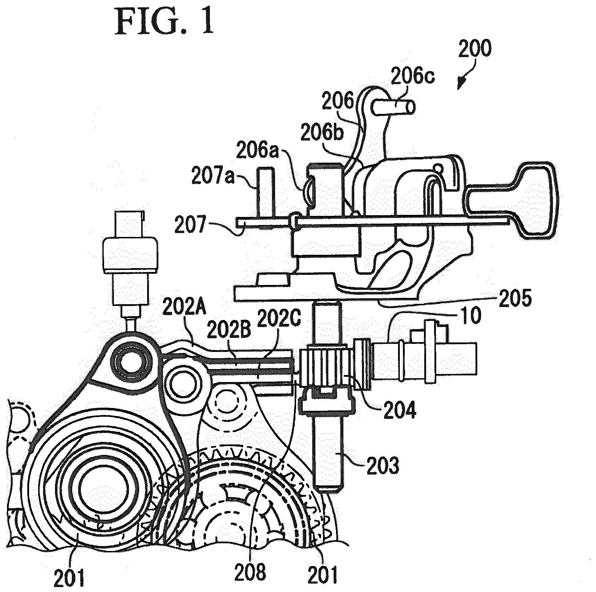

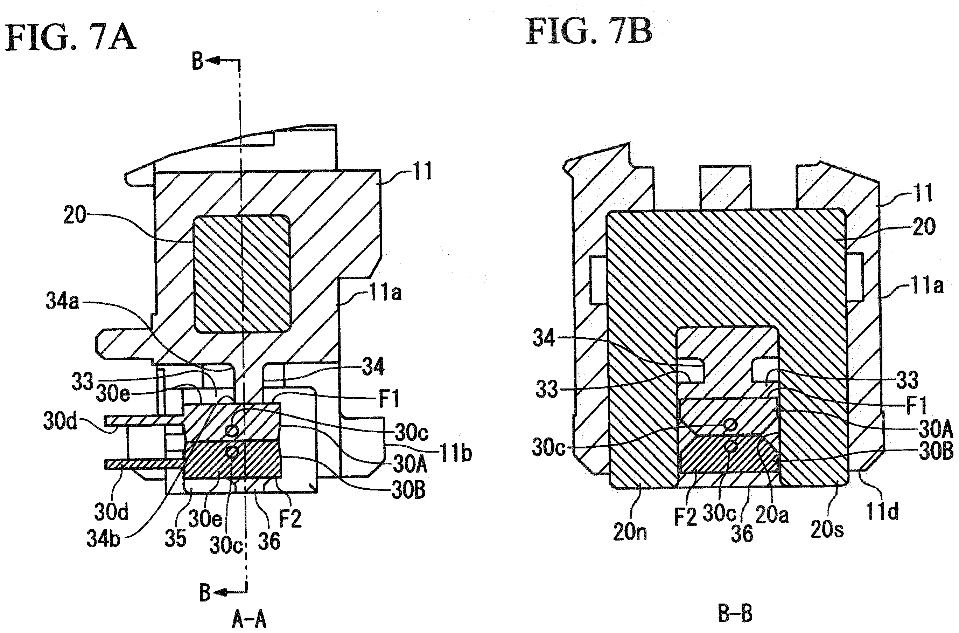

In the following, the present invention is described in detail based on an embodiment shown in the accompanying drawings. FIGS. 1 to 11 are views for describing the configuration of a detecting sensor 10. The detecting sensor 10 is used for detecting whether or not a part constituting an automobile is at a particular position. Of course, the detecting sensor 10 is not limited to the application, and may be used for various applications.

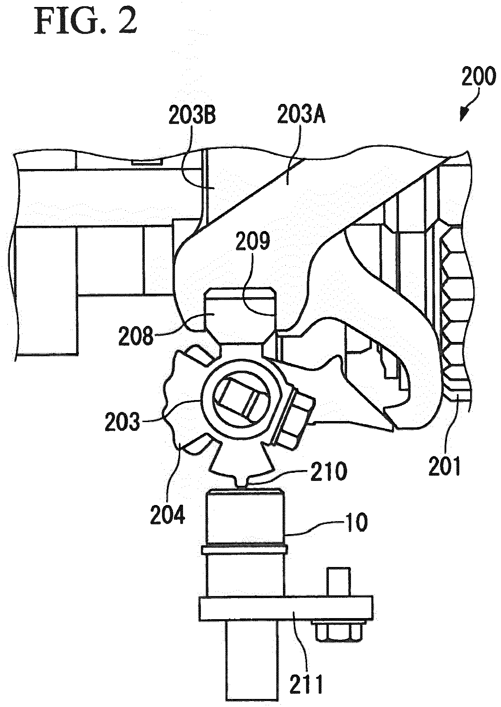

The detecting sensor 10 is used for detecting whether or not shifting of a manual transmission of an automobile is in a neutral state. FIGS. 1 to 3 show an installment example of the detecting sensor 10 in a transmission 200. As shown in FIGS. 1 and 2, the transmission 200 includes a plurality of gears such as first to fifth or first to sixth gears, and when a driver in a driver's seat of an automobile operates an unillustrated shift lever in a longitudinal direction along a traveling direction of the automobile and in a traverse direction perpendicular to the longitudinal direction, a particular gear is selected.
The rotation of an output shaft of an engine is thereby transmitted to a drive shaft for driving a wheel via the selected gear. At this point, a rotation ratio (a speed reducing ratio, a speed increasing ratio) between the output shaft of the engine and the drive shaft for driving a wheel is determined by a gear ratio of the selected gear. Although only the conceptual configuration of the transmission 200 is described herein, one described in, for example, JP2002-235851A may be specifically employed as the transmission 200.

In the transmission 200, three plate-like shift pieces 202A to 202C are provided so as to be stacked on each other in the present embodiment in order to selectively connect a gear 201 constituting each stage to the output shaft of the engine and the drive shaft. Each of the shift pieces 202A to 202C can slide in a direction perpendicular to the stacking direction (a direction perpendicular to the paper face in FIG. 1), and gears 201 of different stages are selected when the shift piece is caused to slide in one direction along its surface from a neutral position and when the shift piece is caused to slide in another direction from the neutral position.

The shift pieces 202A to 202C as described above are operated by a shift arm 204 provided in a shift select shaft 203. The shift select shaft 203 is arranged having an axis line parallel to the stacking direction of the shift pieces 202A to 202C. The shift select shaft 203 is provided so as to be able to reciprocate in an axial direction along a through hole formed in a sleeve 205.

A select arm 206 for moving the shift select shaft 203 in the axial direction is provided at an upper end portion of the shift select shaft 203. In the select arm 206, an intermediate portion 206b is rotatably supported on the sleeve 205, and a pin provided at one end 206a is coupled to the upper end portion of the shift select shaft 203. A pin 206c provided at the other end of the select arm 206 is coupled to an operation wire or an operation rod connected to the unillustrated shift lever. In response to an operation in the traverse (select) direction of the shift lever, the select arm 206 rotates about the intermediate portion 206b, and the shift select shaft 203 thereby reciprocates along the axial direction.

Also, a shift rotor 207 is integrally provided on an outer peripheral side of the shift select shaft 203. A pin 207a that is located on the outer peripheral side of the shift select shaft 203 is provided on the shift rotor 207, and the pin 207a is coupled to an operation wire or an operation rod connected to the unillustrated shift lever. In response to an operation in the longitudinal (shift) direction of the shift lever, the shift rotor 207 rotates together with the shift select shaft 203 about the axis line.

A convex section 208 that projects to the outer peripheral side is formed on the shift arm 204. When the shift lever is operated in the traverse direction, the select arm 206 is actuated to perform a select operation, and the convex section 208 moves in the axial direction of the shift select shaft 203, i.e., the stacking direction of the shift pieces 202A to 202C to face any one of the shift pieces 202A to 202C. A recess 209 with which the convex section 208 meshes is formed in each of distal end portions of the shift pieces 202A to 202C, and when the convex section 208 moves in the stacking direction of the shift pieces 202A to 202C, the convex section 208 is fitted into the recess 209 formed in any one of the shift pieces 202A to 202C.

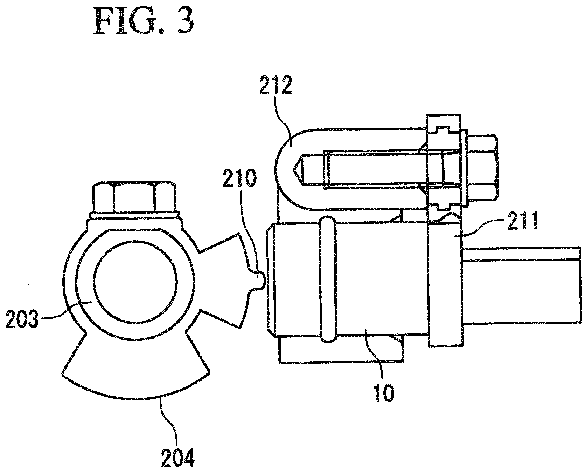

When the shift lever is moved in the longitudinal direction in the state in which the convex section 208 is fitted into the recess 209 formed in any one of the shift pieces 202A to 202C, the shift rotor 207 is actuated to perform a shift operation, and the shift select shaft 203 rotates about the axis line, so that the convex section 208 moves any one (one with which the convex section 208 meshes) of the shift pieces 202A to 202C to one side or another side from the neutral position. Here, a detection projection 210 that projects to the outer peripheral side is provided at a position opposite to the convex section 208 on an outer peripheral portion of the shift arm 204. As shown in FIG. 3, the detecting sensor 10 is provided at a position close to and facing the detection projection 210. The detecting sensor 10 is provided so as to be fixed to a housing 211 of the transmission 200 via a bracket 212. The detection projection 210 is located closest to the detecting sensor 10 in a neutral state in which the shift lever and the shift pieces 202A to 202C are at the neutral position. The detecting sensor 10 detects whether or not the detection projection 210 is at the close position, and thereby detects the rotation of the shift arm 204.

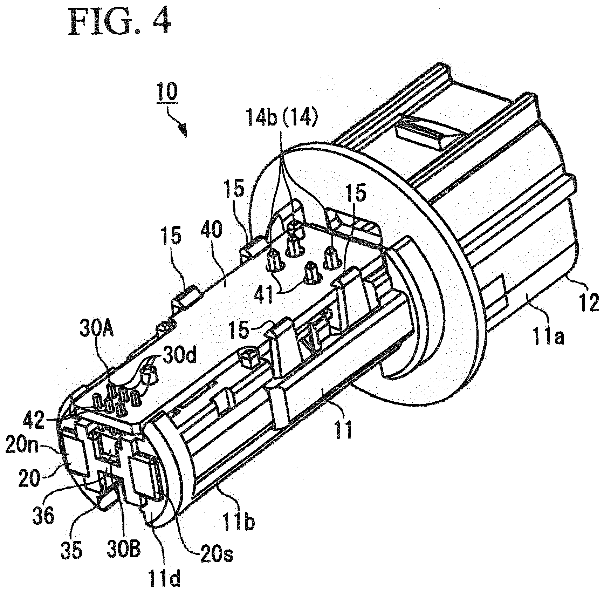

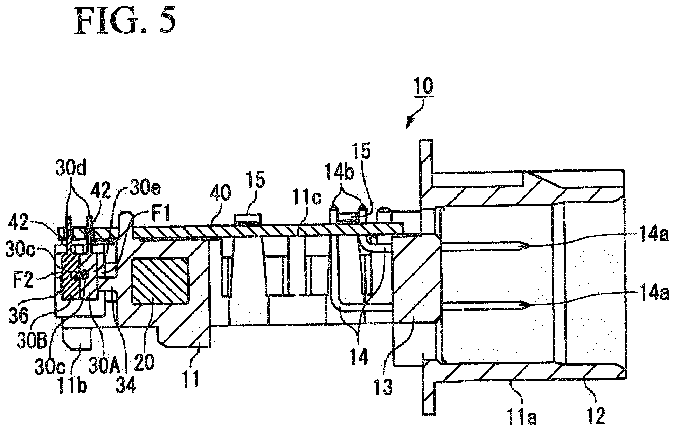

As shown in FIGS. 4 and 5, the detecting sensor 10 is a redundant-system sensor including a housing 11, a magnet (a permanent magnet) 20 having, for example, a substantially U shape in section that is held in the housing 11, a pair of sensor elements 30A and 30B, and a substrate 40.

The housing 11 includes, at one end, a connector receiving section 11a to which a connector of a wire harness is connected, and, at the other end, a sensor holding section 11b that holds the magnet 20, and the sensor elements 30A and 30B.

The connector receiving section 11a includes a tubular sleeve 12, and a terminal holding section 13 that is formed perpendicular to an axis line of the sleeve 12 within the sleeve 12. A plurality of L-shaped terminals 14 made of a conductive material are held in the terminal holding section 13. In each of the terminals 14, one end 14a is connected to each conductor constituting the wire harness inside the sleeve 12, and the other end 14b projects in a direction perpendicular to the axis line of the housing 11 from an intermediate portion of the housing 11.

A flat surface section 11c is formed on a side surface of the housing 11. The substrate 40 has a rectangular shape long in an axial direction of the housing 11, and is arranged along the flat surface section 11c. A plurality of sets of substrate holding claws 15 for holding the substrate 40 are provided at the flat surface section 11c. Each set of the substrate holding claws 15 is provided so as to sandwich the substrate 40 from both sides.

The other ends 14b of the terminals 14 are inserted into through holes 41 formed in the substrate 40, and electrically connected to a wiring pattern of the substrate 40.

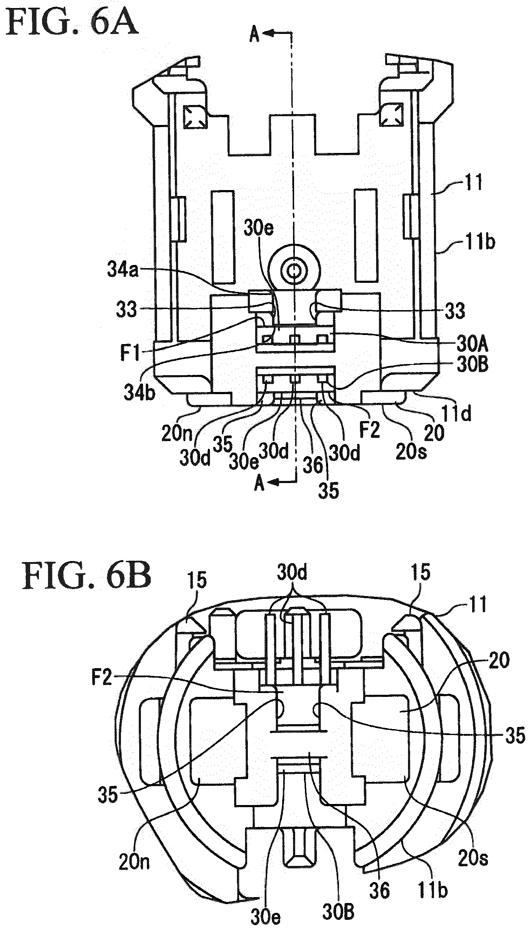

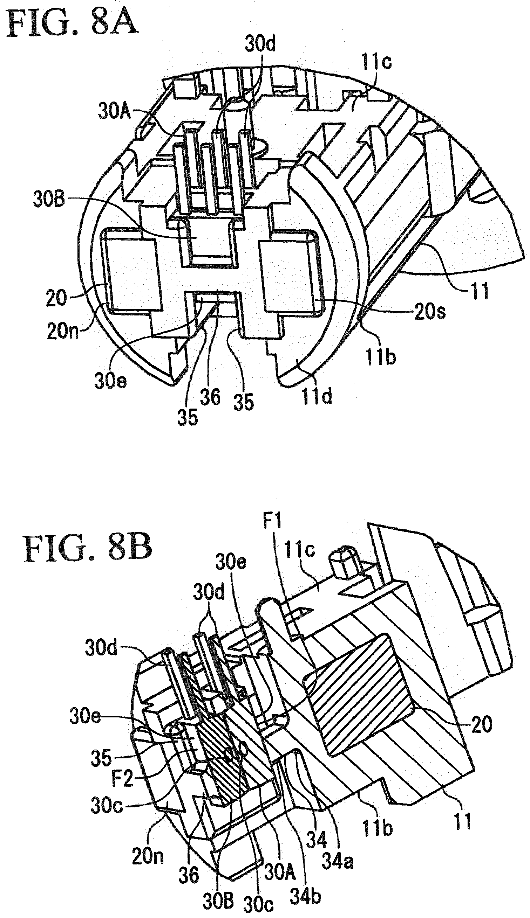

As shown in FIGS. 6A,6B to 8A,8B, the sensor holding section 11b of the housing 11 holds the U-shaped magnet 20 such that both pole sections 20n and 20s extend parallel to the axis line of the housing 11. Furthermore, the sensor holding section 11b holds the magnet 20 such that distal end portions of the both pole sections 20n and 20s are exposed on a distal end surface 11d of the housing 11. Accordingly, the magnet 20 is buried in the housing 11 except for the distal end portions of the both pole sections 20n and 20s.

The sensor elements 30A and 30B are arranged facing each other in a direction along the axis line of the housing 11 in a recess 20a between the both pole sections 20n and 20s in the U-shaped magnet 20. The sensor elements 30A and 30B are, for example, hall elements, in each of which a hall element body 30C and one end of terminals 30d are embedded in a body section 30e made of an insulating material. The sensor elements 30A and 30B are arranged with the body sections 30e and 30e abutting against each other. The hall element bodies 30C and 30C of the sensor elements 30A and 30B are arranged adjacent to each other in the body sections 30e and 30e. Accordingly, the hall element bodies 30C and 30C of the sensor elements 30A and 30B are adjacent to each other to minimize the influence of a magnetic (magnetic field) strain. The other ends of the terminals 30d are inserted into through holes 42 formed in the substrate 40, and electrically connected to the wiring pattern of the substrate 40. At this point, the sensor elements 30A and 30B are arranged such that the terminals 30d project in the same direction perpendicular to the axial direction of the housing 11 from the body sections 30e.

The sensor elements 30A and 30B as described above are held in the housing 11 as described below. The housing 11 includes holding sections 33 and 34 that hold the sensor elements 30A and 30B facing each other in the direction along the axis line from the side of the sensor element 30A, and holding sections 35 and 36 that hold the sensor elements 30A and 30B from the side of the sensor element 30B.

Among the sections, the holding sections 33 and 35 are formed so as to extend along two sides parallel to each other of the body sections 30e of the sensor elements 30A and 30B, and abut against both sides of surfaces F1 and F2 of the body sections 30e and 30e.

Also, the holding section (a positioning holding section, a first holding section) 34 has a columnar shape arranged substantially in a center portion of the body section 30e of the sensor element 30A, and extending toward the body section 30e from a perpendicular direction. A distal end portion 34b of the holding section 34 abuts against the center portion of the surface F1 of the body section 30e.

The holding section (a positioning holding section, a second holding section) 36 is provided so as to extend along the body section 30e in a direction perpendicular to the holding sections 35 and 35 located on the both sides of the body section 30e of the sensor element 30B. Accordingly, the holding section 36 abuts against the surface F2 of the body section 30e of the sensor element 30B in a substantially H shape together with the holding sections 35 and 35 on the both sides.

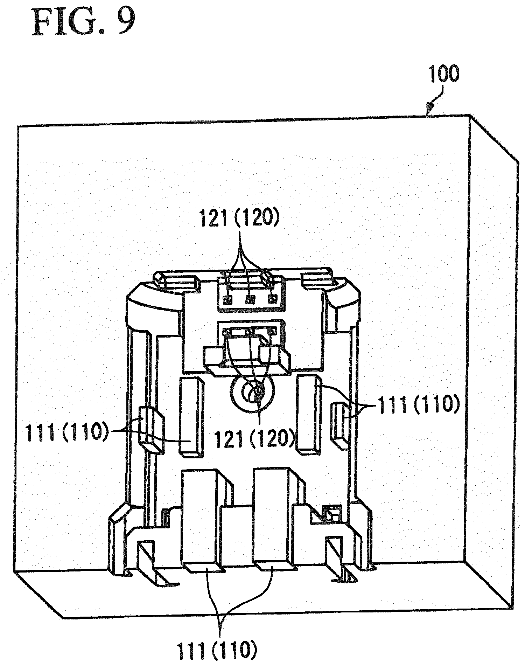

To manufacture the detecting sensor 10 having the aforementioned configuration, a magnet holding section 110 for holding the magnet 20 and an element holding section 120 for holding the sensor elements 30A and 30B are provided in a mold 100 for forming the housing 11 by resin molding as shown in FIG. 9, and the housing 11 is formed using the mold 100.

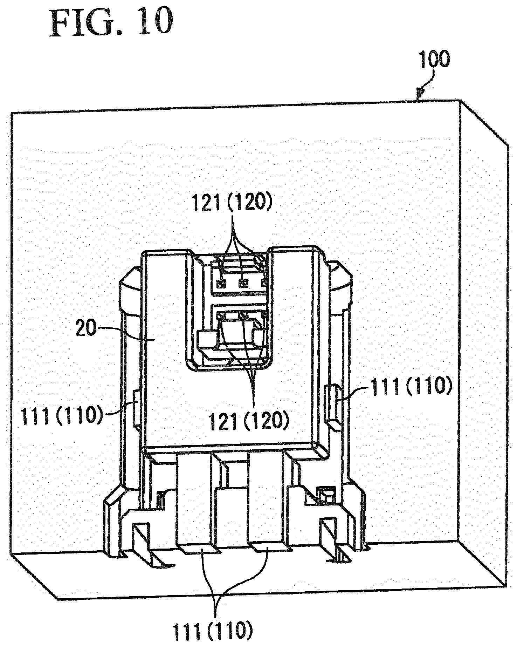

As shown in FIGS. 9 and 10, the magnet holding section 110 holds the magnet 20 by a plurality of holding projections 111.

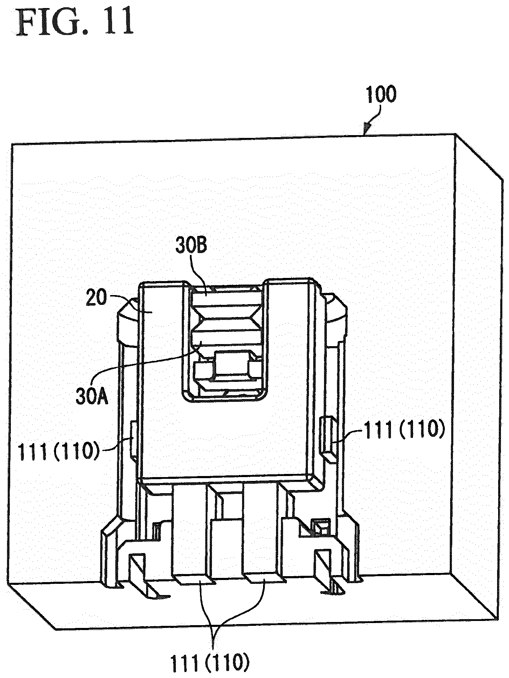

As shown in FIGS. 9 and 11, the element holding section 120 includes terminal insertion holes 121 into which the terminals 30d of the sensor elements 30A and 30B are respectively inserted. By inserting the terminals 30d into the terminal insertion holes 121, the sensor elements 30A and 30B are respectively held by the mold 100.

In a state in which the openable mold 100 is opened, the magnet 20 and the sensor elements 30A and 30B are held in the mold 100 by the magnet holding section 110 and the element holding section 120. The mold 100 is closed in this state, and resin is injected into the mold 100.

At this point, particularly in the holding section 34 extending in a columnar shape, the resin in a molten state flows from the side of a proximal end portion 34a to the side of the distal end portion 34b. Accordingly, the sensor elements 30A and 30B are pressed against the holding sections 35 and 36 on the opposite side.

The mold 100 is opened after curing of the resin to remove the detecting sensor 10.

The detecting sensor 10 is thereby obtained. A bottomed tubular cover (not shown) is mounted to the detecting sensor 10 so as to cover the magnet 20, the sensor elements 30A and 30B, and the substrate 40.

In accordance with the aforementioned configuration, in the detecting sensor 10, the sensor elements 30A and 30B are formed integrally with the housing 11. At this point, the sensor elements 30A and 30B are positioned and fixed by inserting the terminals 30d into the mold 100 used in molding, so that the sensor elements 30A and 30B can be positioned with respect to the housing 11 with high accuracy. Therefore, high detection accuracy can be maintained for the sensor elements 30A and 30B. Moreover, this is achieved only by forming the terminal insertion holes 121 in the mold 100, so that high detection accuracy can be stably provided at low cost.

Also, in the detecting sensor 10, the sensor elements 30A and 30B are held by the holding sections 33, 34, 35, and 36 in abutment against the surfaces F1 and F2 of the body sections 30e and 30e. Since the sensor elements 30A and 30B are sandwiched in a state facing each other by 33, 34, 35, and 36, the sensor elements 30A and 30B can be reliably held. Also, since the holding sections 33, 34, 35, and 36 abut against only a portion, not the entire surface, of the surfaces F1 and F2 of the body sections 30e, heat dissipation properties of the sensor elements 30A and 30B can be ensured.

The detecting sensor 10 as described above can also detect whether or not the detection projection 210 formed on the rotating sleeve 205 is at a prescribed position (a neutral position) in a non-contact manner. The non-contact detecting sensor 10 as described above can exhibit excellent reliability since the detecting sensor 10 has no movable portion and thus has a fewer failures as compared to a contact switch.

Furthermore, in the detecting sensor 10, the body sections 30e and 30e of the sensor elements 30A and 30B abut against each other, so that the detecting sensor 10 can be reduced in size, easily arranged in the transmission 200, and mounted at low cost. Also, while an object to be detected is the shift arm 204 rotating together with the shift select shaft 203, the influence of a magnetic (magnetic field) strain can be minimized since the hall element bodies 30C and 30C of the sensor elements 30A and 30B are arranged adjacent to each other in the body sections 30e and 30e. The detection accuracy of the detecting sensor 10 can be thereby improved.

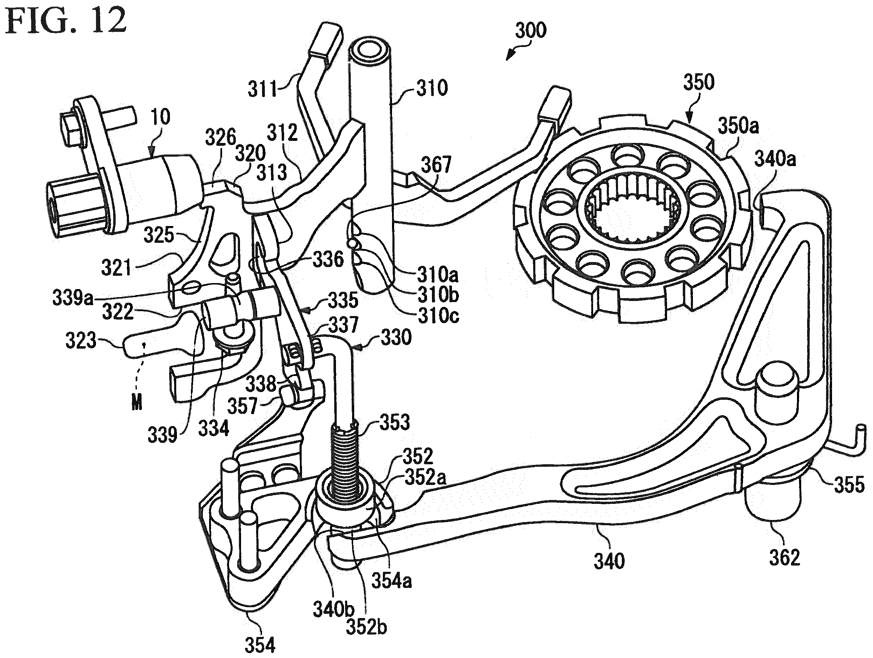

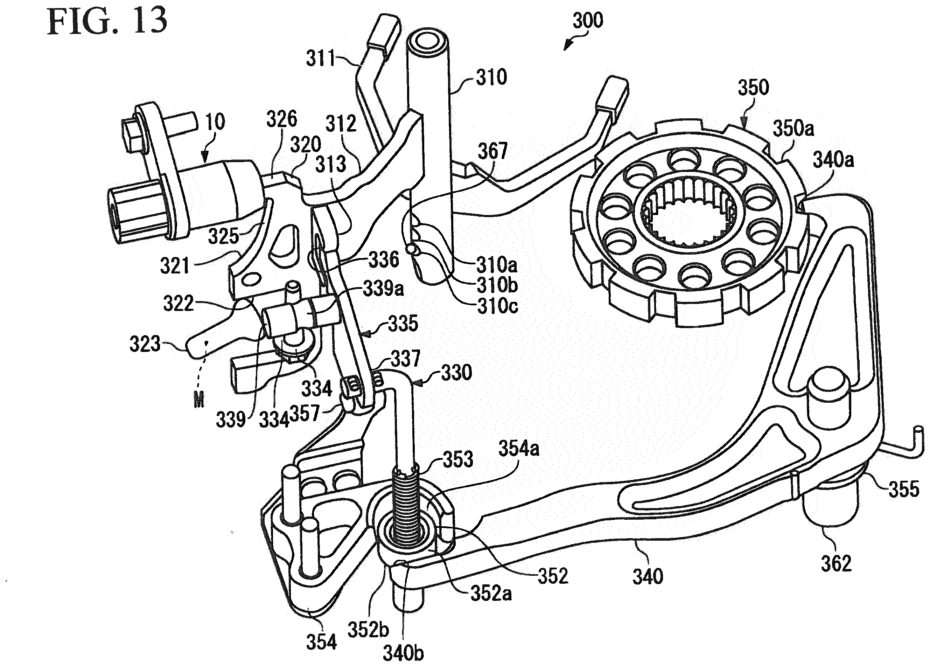

Although the detecting sensor 10 is used for detecting whether or not the shifting of the manual transmission of the automobile is in the neutral state in the aforementioned embodiment, the detecting sensor 10 may be also used for detecting whether or not an automatic transmission is in a parking state as described below based on FIGS. 12 and 13.

First, a parking lock device 300 of the automatic transmission according to the present embodiment is described by reference to FIG. 12. The parking lock device 300 is applied to a transmission that can establish a predetermined gear speed by operating a meshing clutch provided on a gear shift shaft by a shift rod 310 connected to and actuated by an actuator M. FIG. 12 shows the parking lock device 300 in a neutral state. The parking lock device 300 includes a parking gear 350 that is provided on a reverse idle shaft moving in conjunction with the drive shaft when the vehicle is stopped, a parking pawl 340 that can be engaged with the parking gear 350, and a parking rod 330 that moves in conjunction with the shift rod 310 to actuate the parking pawl 340. The parking lock device 300 can bring the parking gear 350 into a lock state by transmitting the operation of a shift piece 320 formed integrally with the shift rod 310 to the parking pawl 340 via the parking rod 330.

In the parking lock device 300, the shift rod 310 can axially move and selectively stop at three positions of a neutral position, a reverse position, and a parking position in a clicked manner. The shift rod 310 is detected to be in a parking state or not when the shift piece 320 integrated therewith axially moves by the actuator M, and the detecting sensor 10 detects the position. To this end, three detent grooves 310a, 310b, and 310c are formed in the shift rod 310, so that the shift rod 310 is at the neutral position when a detent ball 367 urged by an unillustrated spring is engaged with the detent groove 310b, and at the parking position when the detent ball 367 is engaged with the detent groove 310c. Therefore, when the shift rod 310 is changed from, for example, the neutral state to the parking state, the shift rod 310 moves upwardly in the drawing. A shift fork 311 and a coupling beam 312 are formed integrally with the shift rod 310. The coupling beam 312 integrally couples the shift rod 310 to the shift piece 320. A locking claw 313 is also formed integrally with the coupling beam 312.

The shift piece 320 includes a cam section 321 and a detection arm 325. A cam groove 322 that penetrates through the cam section 321 and opens at one end is formed in the cam section 321, and one end side of a cam plate 323 is inserted into the cam groove 322 through the opening. In the cam plate 323 where one end side is set to a large width, the actuator M is connected to the other end side, and when the actuator M forwardly and reversely rotates the cam plate 323, the shift rod 310 moves up and down. For example, when the actuator M is forwardly rotated counterclockwise, the cam plate 323 presses the cam section 321 upwardly in the drawing, and the shift rod 310 moves up. In the following, up, down, left, and right indicate directions in the drawings. The detection arm 325 is formed integrally with an upper portion of the cam section 321, and raised and lowered in association with the up-and-down movement of the cam section 321. A detection projection 326 is formed at a distal end of the detection arm 325, and the detecting sensor 10 is arranged facing and close to the detection projection 326. A relative position relationship between the detecting sensor 10 and the detection projection 326 is changed between the neutral state and the parking state, so that the detecting sensor 10 can detect whether or not the state is in the parking state.

The parking rod 330 transmits the up-and-down movement of the shift piece 320 (the shift rod 310) to the parking pawl 340. To this end, the parking rod 330 is coupled to the locking claw 313 of the coupling beam 312 via a swing arm 335. The swing arm 335 includes a locking claw 336 that is engaged with the locking claw 313 on one end side. The swing arm 335 also includes, on the other end side, a rod holding hole 337 where a distal end bent in an L shape of the parking rod 330 is held by penetrating therethrough, and a locking projection 338 that is located below the rod holding hole 337 and engaged with a locking spring piece 357. A positioning rod 339 is provided on one side surface of the swing arm 335, and the swing arm 335 performs swing motion about the axis of the positioning rod 339. Therefore, when the shift piece 320 moves up by the actuator M, the swing arm 335 rotates clockwise in conjunction therewith, and the parking rod 330 moves down substantially parallel to the shift rod 310. Conversely, when the shift piece 320 moves down, the swing arm 335 swings counterclockwise, and the parking rod 330 moves up. An arc-shaped groove 339a continuous in a circumferential direction is formed in the outer periphery of the positioning rod 339, and a columnar support pin 334 is inserted into the groove 339a. Therefore, the support pin 334 regulates movement of the swing arm 335 in an axial direction of the positioning rod 339 while allowing the rotational movement of the swing arm 335.

A cam member 352 is slidably fitted to the parking rod 330. The cam member 352 includes an equal-diameter section 352a and a tapered section 352b whose diameter is gradually decreased from a lower end of the equal-diameter section 352a. The cam member 352 is urged downwardly by a compressed coil spring 353 provided around the parking rod 330. When the parking rod 330 moves down in the parking state, the cam member 352 is urged downwardly by a stronger force. A cam receiving section 340b of the parking pawl 340 and a cam receiving section 354a of a parking rod holder 354 are arranged near the cam member 352. The cam receiving section 340b and the cam receiving section 354a include tapered surfaces corresponding to the tapered section 352b on their surfaces. Since the parking rod 330 is located relatively high in the neutral state shown in FIG. 12, the cam member 352 is pressed against the cam receiving section 340b and the cam receiving section 354a by a relatively weak force. The position of the parking rod holder 354 is fixed.

The parking pawl 340 locks and unlocks the parking gear 350 in conjunction with the operation of the parking rod 330.

The L-shaped parking pawl 340 is swingably supported in a bend portion by a support shaft 362 whose position is fixed. In the parking pawl 340, an engagement claw 340a that is engaged with a tooth groove 350a formed in the outer periphery of the parking gear 350 is formed at one distal end, and the cam receiving section 340b is formed at the other distal end. The parking pawl 340 is urged in a direction in which the engagement claw 340a moves away from the parking gear 350 by a torsional spring 355 provided on the outer periphery of the support shaft 362. Therefore, in the neutral state, while the engagement claw 340a is released from the tooth groove 350a, a distance between the cam receiving section 340b and the cam receiving section 354a of the parking rod holder 354 is reduced. However, in the parking state, the parking rod 330 moves down, and the cam member 352 is thereby pressed down, so that the cam member 352 pushes itself into a space between the cam receiving section 340b and the cam receiving section 354a. Since the position of the cam receiving section 354a is fixed, the parking pawl 340 rotates counterclockwise when a force that the cam receiving section 340b receives from the tapered section 352b becomes larger than a force that the parking pawl 340 receives from the torsional spring 355.

The parking gear 350 is fixed to the reverse idle shaft (not shown) moving in conjunction with the drive shaft when the vehicle is stopped, and the parking state is ensured by locking the parking gear 350. The parking gear 350 is arranged corresponding to the engagement claw 340a of the parking pawl 340, and when the parking pawl 340 rotates counterclockwise as described above, the engagement claw 340a is inserted into the tooth groove 350a to lock the parking gear 350.

Next, the operation of a process in which the parking lock device 300 is shifted from the neutral state to the parking state is described by reference to FIG. 13. When the shifting is changed from the neutral state to the parking state, the actuator M rotates the cam plate 323 counterclockwise. Accordingly, the shift piece 320 moves up, and the parking pawl 340 follows the operation of the swing arm 335 and the parking rod 330 in association with the movement to rotate counterclockwise from a position in FIG. 12 to a position in FIG. 13. As a result, the parking gear 350 is locked. In this state, the cam member 352 is sandwiched between the cam receiving section 340b and the cam receiving section 354a. Also, when the parking rod 330 moves down to the parking state, the locking projection 338 climbs over a distal end of the locking spring piece 357, so that the parking rod 330 is prevented from moving up by mistake. Therefore, the parking lock state is stably maintained.

When the shift piece 320 moves up, the detection projection 326 also follows the movement to move up. That is, the position of the detection projection 326 close to the detecting sensor 10 differs between the neutral state and the parking state. Therefore, the detecting sensor 10 detects the displacement of the detection projection 326 to thereby determine whether or not the state is in the parking state. The mounting position of the detecting sensor 10 is not limited to the aforementioned position, and may be installed close to another member whose position moves in conjunction with the shift rod 310. For example, the detecting sensor 10 may be installed close to an upper end of the shift rod 310, or close to an upper end of the parking rod 330.

Although the present invention has been described by using the detecting sensor 10 for detecting the position of a part constituting an automobile as an example, the present invention is not limited to the application. Also, although the magnet 20 has a substantially U shape in section, the magnet 20 is not limited thereto, and may have another appropriate shape. Also, as long as the same effects as those described above are obtained, the arrangement, the installed number, the shape or the like of the holding sections 33, 34, 35, and 36 may have a configuration other than those described above. The constitutions described in the aforementioned embodiment may be also freely selected or changed into other constitutions without departing from the scope of the present invention.

### Reference Signs List

- 10: Detecting sensor
- 11: Housing
- 11a: Connector receiving section
- 11b: Sensor holding section
- 14: Terminal
- 15: Substrate holding claw
- 20: Magnet
- 20a: Recess
- 20n, 20s: Both pole section
- 30A, 30B: Sensor element
- 30C: Hall element body
- 30d: Terminal
- 30e: Body section
- 34: Holding section (Positioning holding section, First holding section)
- 34a: Proximal end portion
- 34b: Distal end portion
- 36: Holding section (Positioning holding section, Second holding section)
- 40: Substrate
- 100: Mold
- 110: Magnet holding section
- 111: Holding projection
- 120: Element holding section
- 121: Terminal insertion hole
- 202A to 202C: Shift piece
- 200: Transmission
- 201: Gear
- 203: Shift select shaft
- 204: Shift arm
- 206: Select arm
- 207: Shift rotor
- 210: Detection projection
- 211: Housing
- 300: Parking lock device
- 310: Shift rod
- 310a, 310b, 310c: Detent groove
- 313: Locking claw
- 320: Shift piece
- 323: Cam plate
- 326: Detection projection
- 330: Parking rod
- 334: Support pin
- 335: Swing arm
- 338: Locking projection
- 339: Positioning rod
- 339a: Groove
- 340: Parking pawl
- 340a: Engagement claw
- 340b: Cam receiving section
- 350: Parking gear
- 352: Cam member
- 352a: Equal-diameter section
- 352b: Tapered section
- 353: Coil spring
- 354: Parking rod holder
- 357: Locking spring piece
- 367: Detent ball

## Claims

1. A method for manufacturing a detecting sensor (10) comprising:
a magnet (20) that generates a magnetic field;
a plurality of sensor elements (30A, 30B) that detect a change in the magnetic field generated by the magnet (20); and
a housing (211) that holds the magnet (20) and the sensor elements (30A, 30B), the method comprising the steps of:
fixing the magnet (20) and the sensor elements (30A, 30B) to a mold (100);
molding the housing (211) by injecting molten resin into the mold (100) and curing the molten resin; and
removing the detecting sensor (10) in which the magnet (20) and the sensor elements (30A, 30B) are integrated with the housing (211) from the mold (100), **characterised in that** in the step of fixing the magnet (20) and the sensor elements (30A, 30B) to the mold (100), the sensor elements (30A, 30B) are fixed to the mold (100) by inserting terminals (30d) projecting from bodies (30e) of the sensor elements (30A, 30B) into terminal insertion holes (121) formed in the mold (100).

2. The method for manufacturing a detecting sensor (10) according to claim 1, wherein the housing (211) includes a positioning holding section (34) that positions each of the sensor elements (30A, 30B) by abutting against only a portion of a surface of the body (30e) of the sensor element (30A, 30B).

3. The method for manufacturing a detecting sensor (10) according to claim 2, wherein the positioning holding section (34) holds each of the sensor elements (30A, 30B) by extending in a direction perpendicular to the surface of the body (30e) of the sensor element (30A, 30B) and causing a distal end portion (34b) thereof to abut against the body (30e), and
in the step of molding the housing (11), the molten resin is caused to flow from a proximal end portion (34a) to the distal end portion (34b) of the positioning holding section (34) to press the body (30e) of the sensor element (30A, 30B) by the molten resin and form the positioning holding section (34).

4. The method for manufacturing a detecting sensor (10) according to claim 1, wherein the plurality of sensor elements (30A, 30B) are arranged with the surfaces of the bodies (30e) abutting against each other.

5. The method for manufacturing a detecting sensor (10) according to claim 4, wherein detecting element bodies of the plurality of sensor elements (30A, 30B) are arranged adjacent to each other.

## Patentansprüche

1. Verfahren zur Herstellung eines Detektionssensors (10), der Folgendes beinhaltet:
einen Magnet (20), der ein Magnetfeld erzeugt;
mehrere Sensorelemente (30A, 30B), die eine Änderung in dem von dem Magnet (20) erzeugten Magnetfeld detektieren; und
ein Gehäuse (211), das den Magnet (20) und die Sensorelemente (30A, 30B) hält, wobei das Verfahren die folgenden Schritte beinhaltet:
Befestigen des Magnets (20) und der Sensorelemente (30A, 30B) an einer Form (100);
Formen des Gehäuses (211) durch Injizieren von geschmolzenem Harz in die Form (100) und Härten des geschmolzenen Harzes; und
Entfernen des Detektionssensors (10), in dem der Magnet (20) und die Sensorelemente (30A, 30B) mit dem Gehäuse (211) integriert sind, aus der Form (100),
**dadurch gekennzeichnet, dass** in dem Schritt des Befestigens des Magnets (20) und der Sensorelemente (30A, 30B) an der Form (100) die Sensorelemente (30A, 30B) durch Einführen von Anschlussklemmen (30d) an der Form (100) befestigt werden, die von Körpern (30e) der Sensorelemente (30A, 30B) in Klemmeneinführungslöcher (121) vorstehen, die in der Form (100) ausgebildet sind.

2. Verfahren zur Herstellung eines Detektionssensors (10) nach Anspruch 1, wobei das Gehäuse (211) einen Positionshalteabschnitt (34) aufweist, der jedes der Sensorelemente (30A, 30B) durch Anlage an nur einem Teil einer Oberfläche des Körpers (30e) des Sensorelements (30A, 30B) positioniert.

3. Verfahren zur Herstellung eines Detektionssensors (10) nach Anspruch 2, wobei der Positionshalteabschnitt (34) jedes der Sensorelemente (30A, 30B) hält, indem er in einer Richtung lotrecht zur Oberfläche des Körpers (30e) des Sensorelements (30A, 30B) verläuft und bewirkt, dass ein distaler Endteil (34b) davon an dem Körper (30e) anliegt, und
wobei in dem Schritt des Formens des Gehäuses (11) bewirkt wird, dass das geschmolzene Harz von einem proximalen Endteil (34a) zum distalen Endteil (34b) des Positionshalteabschnitts (34) fließt, um gegen den Körper (30e) des Sensorelements (30A, 30B) mit dem geschmolzenen Harz zu pressen und den Positionshalteabschnitt (34) zu bilden.

4. Verfahren zur Herstellung eines Detektionssensors (10) nach Anspruch 1, wobei die mehreren Sensorelemente (30A, 30B) mit den Oberflächen der Körper (30e) aneinander anliegend angeordnet sind.

5. Verfahren zur Herstellung eines Detektionssensors (10) nach Anspruch 4, wobei Sensorelementekörper der mehreren Sensorelemente (30A, 30B) nebeneinander angeordnet sind.

## Revendications

1. Procédé pour fabriquer un capteur de détection (10) comprenant :
un aimant (20) qui génère un champ magnétique ;
une pluralité d'éléments de capteur (30A, 30B) qui détectent un changement dans le champ magnétique généré par l'aimant (20) ; et
un logement (211) qui abrite l'aimant (20) et les éléments de capteur (30A, 30B), le procédé comprenant les étapes consistant à :
fixer l'aimant (20) et les éléments de capteur (30A, 30B) sur un moule (100) ;
mouler le logement (211) en injectant de la résine fondue dans le moule (100) et faire durcir la résine fondue ; et
enlever, du moule (100), le capteur de détection (10) dans lequel l'aimant (20) et les éléments de capteur (30A, 30B) sont intégrés avec le logement (211),
**caractérisé en ce que**
dans l'étape de fixation de l'aimant (20) et des éléments de capteur (30A, 30B) sur le moule (100), les éléments de capteur (30A, 30B) sont fixés sur le moule (100) grâce à l'insertion de bornes (30d) faisant saillie des corps (30e) des éléments de capteur (30A, 30B) dans les trous d'insertion de borne (121) formés dans le moule (100).

2. Procédé pour fabriquer un capteur de détection (10) selon la revendication 1, le logement (211) incluant une section de maintien du positionnement (34) qui positionne chacun des éléments de capteur (30A, 30B) en le faisant buter contre une portion uniquement d'une surface du corps (30e) de l'élément de capteur (30A, 30B).

3. Procédé pour fabriquer un capteur de détection (10) selon la revendication 2, la section de maintien du positionnement (34) maintenant chacun des éléments de capteur (30A, 30B) en s'étendant suivant une direction qui est perpendiculaire à la surface du corps (30e) de l'élément de capteur (30A, 30B) et amenant une portion d'extrémité distale (34b) de celle-ci à être en butée contre le corps (30e), et
dans l'étape de moulage du logement (11), la résine fondue est amenée à couler à partir d'une portion d'extrémité proximale (34a) jusqu'à la portion d'extrémité distale (34b) de la section de maintien du positionnement (34) afin de presser le corps (30e) de l'élément de capteur (30A, 30B) grâce à la résine fondue et former la section de maintien du positionnement (34).

4. Procédé pour fabriquer un capteur de détection (10) selon la revendication 1, la pluralité d'éléments de capteur (30A, 30B) étant agencés pour que les surfaces des corps (30e) soient en butée l'une contre l'autre.

5. Procédé pour fabriquer un capteur de détection (10) selon la revendication 4, des corps d'éléments de capteur de la pluralité d'éléments de capteur (30A, 30B) étant agencés de manière adjacente l'un à l'autre.
